(19) Europäisches Patentamt
European Patent Office
Office européen des brevets

(11) **EP 3 494 394 B1**

(12) **EUROPÄISCHE PATENTSCHRIFT**

(45) Veröffentlichungstag und Bekanntmachung des Hinweises auf die Patenterteilung:
**12.06.2024   Patentblatt 2024/24**

(21) Anmeldenummer: **17755429.2**

(22) Anmeldetag: **02.08.2017**

(51) Internationale Patentklassifikation (IPC):
**G01N 27/72** *(2006.01)*       **G01R 33/04** *(2006.01)*

(52) Gemeinsame Patentklassifikation (CPC):
**G01N 27/72; G01R 33/04; G01R 33/045; G01R 33/1223**

(86) Internationale Anmeldenummer:
**PCT/EP2017/069583**

(87) Internationale Veröffentlichungsnummer:
**WO 2018/024800 (08.02.2018 Gazette 2018/06)**

(54) **VORRICHTUNG UND VERFAHREN ZUR ZERSTÖRUNGSFREIEN GEHALTSBESTIMMUNG DES MAGNETISIERBAREN UND/ODER NICHT-MAGNETISIERBAREN ANTEILS EINER PROBE**

APPARATUS AND METHOD FOR NON-DESTRUCTIVE DETERMINATION OF THE CONTENT OF MAGNETISABLE PART AND/OR NON- MAGNETISABLE PART OF A SAMPLE

DISPOSITIF ET PROCEDE DESTINES A LA DETERMINATION NON DESTRUCTIVE DE LA TENEUR DE LA PARTIE MAGNETISABLE ET/OU NON MAGNETISABLE D'UN ECHANTILLON

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **02.08.2016   EP 16182466**

(43) Veröffentlichungstag der Anmeldung:
**12.06.2019   Patentblatt 2019/24**

(73) Patentinhaber: **voestalpine Stahl GmbH**
**4020 Linz (AT)**

(72) Erfinder:
• **SCHUSTER, Stefan**
  **4470 Enns (AT)**

• **GSTÖTTENBAUER, Norbert**
  **4209 Engerwitzdorf (AT)**
• **THALER, Christoph**
  **4020 Linz (AT)**
• **WÖCKINGER, Daniel**
  **4209 Engerwitzdorf (AT)**

(74) Vertreter: **Jell, Friedrich**
**Bismarckstrasse 9**
**4020 Linz (AT)**

(56) Entgegenhaltungen:
EP-A2- 0 267 896      US-A- 2 755 433
US-A- 3 337 795      US-A- 4 394 193

**Beschreibung**

Technisches Gebiet

Die Erfindung betrifft eine Vorrichtung und ein Verfahren zur zerstörungsfreien Gehaltsbestimmung des magnetisierbaren und/oder nicht-magnetisierbaren Anteils einer Probe, bei dem in einem Luftspalt eines magnetisch leitenden Jochs die Probe vorgesehen wird, durch eine magnetische Wechselfeldstärke einer Erregerspule im Joch ein magnetisches Wechselfeld erzeugt und mit mindestens einer induktiv mit dem Joch gekoppelten Messeinrichtung erste Messdaten der Probe erfasst werden, und mit Hilfe eines Vergleichs der ersten Messdaten mit zweiten Messdaten von einer Referenzprobe, mit bekanntem magnetisierbarem und/oder nicht-magnetisierbarem Gehaltsanteil, der magnetisierbare und/oder nicht-magnetisierbare Gehaltsanteil in der Probe bestimmt wird.

Stand der Technik

Aus dem Stand der Technik sind zerstörungsfreie Verfahren bekannt (EP0267896A2), mit denen der magnetisierbare und nicht-magnetisierbare bzw. ferromagnetische Gehaltsanteil einer Probe bestimmt werden kann. Dabei wird die zu messende Probe in einem Luftspalt eines magnetisch leitenden Jochs vorgesehen, das über eine Erregerspule mit einer bestimmten magnetischen Feldstärke beaufschlagt wird. Die Erregerspule ist Teil eines elektrischen Schwingkreises, dessen Resonanzfrequenz sich in Abhängigkeit des magnetisierbaren bzw. nicht-magnetisierbaren Anteils der Proben verändert. Mit einer Messeinrichtung wird bei einer Messfrequenz von diesem Schwingkreis ein Messstrom abgegriffen und dazu verwendet, auf den Gehalt an magnetisierbaren bzw. nicht-magnetisierbaren Anteil in der Probe rückzuschließen. Ein derartiges Verfahren ist jedoch vergleichsweise störanfällig und erfordert zudem ein komplexes Auswerteverfahren - insbesondere, weil die magnetische Permeabilität $\mu$ einen nicht-linearen Verlauf aufweist.

Aus der US3337795A und US2755433A sind Verfahren bekannt, die an einem Joch Unterschiede zwischen einer Probe und einer Referenzprobe erkennen.

Darstellung der Erfindung

Die Erfindung hat sich daher die Aufgabe gestellt, ein Verfahren der eingangs erwähnten Art derart zu verbessern, dass dieses schneller durchzuführen ist und dennoch eine hohe Zuverlässigkeit aufweist.

Die Erfindung löst die gestellte Aufgabe hinsichtlich des Verfahrens dadurch, dass bei der Erfassung der ersten und zweiten Messdaten der Probe und Referenzprobe mit Hilfe der Erregerspule die gleiche magnetische Wechselfeldstärke oder das gleiche magnetische Wechselfeld sowohl in die Referenzprobe als auch in die Probe eingeprägt wird, und die Differenz der beiden erfassten Messdaten als Maß in die Gehaltsbestimmung für den magnetisierbaren und/oder nicht-magnetisierbaren Gehaltsanteil der Probe eingeht.

Erfindungsgemäß wird bei der Erfassung der ersten und zweiten Messdaten der Probe und Referenzprobe mit Hilfe der Erregerspule die gleiche magnetische Wechselfeldstärke oder das gleiche magnetische Wechselfeld sowohl in die Referenzprobe als auch in die Probe eingeprägt. Somit können trotz der nicht-linearen magnetischen Permeabilität $\mu$ bzw. deren Funktions-Abhängigkeit vom magnetisierbaren und/oder nicht-magnetisierbaren Gehaltsanteil vergleichbare Messdaten von Probe und Referenzprobe gewonnen werden.

Dies kann beispielsweise in einer ersten Variante durch das Einprägen einer magnetischen Wechselfeldstärke mit identischem zeitlichem Signalverlauf (Frequenz und Amplitude) sowohl in die Probe als auch in die Referenzprobe (etwa durch Regelung des Stroms i(t) der Erregerspule) erzielt werden. Dabei kann - unter Annahme einer (im Messbereich) konstanten Permeabilität des Jochs $\mu_J$ - auch dessen magnetischer Widerstand $R_J$ als konstant angenommen werden. Die magnetischen Widerstände der Referenzprobe $R_{ref}$ und der Probe $R_p$ können damit als Funktionen der magnetischen Durchflutung $\Theta_E$ (erzeugt durch die Erregerspule) und des magnetischen Flusses $\Phi_{ref}$ in der Referenzprobe bzw. des magnetischen Flusses $\Phi_p$ in der Probe ausgedrückt werden:

$$R_{ref} = \frac{\Theta_E(t)}{\Phi_{ref}(t)} - R_J \qquad (1)$$

$$R_p = \frac{\Theta_E(t)}{\Phi_p(t)} - R_J \qquad (2)$$

In einer zweiten Variante kann durch Einprägen eines gleichen magnetischen Wechselfelds B erreicht werden, dass zu jedem Zeitpunkt der gleiche magnetische Fluss $\Phi_p$ bzw. $\Phi_{ref}$ durch die Probe, die Referenzprobe und das Joch

fließt ($\Phi_{\text{ref}} = \Phi_{\text{p}}$). Die magnetischen Widerstände der Referenzprobe $R_{\text{ref}}$ und der Probe $R_{\text{p}}$ können damit wiederum als Funktionen des magnetischen Flusses $\Phi_{\text{p}}$ bzw. $\Phi_{\text{ref}}$ ausgedrückt werden:

$$R_{\text{ref}} = \frac{\Theta_{\text{E}}(t)}{\Phi_{\text{ref}}(t)} - R_J(\Phi_{\text{ref}}(t)) \qquad (3)$$

$$R_{\text{p}} = \frac{\Theta_{\text{E}}(t)}{\Phi_{\text{p}}(t)} - R_J(\Phi_{\text{ref}}(t)) \qquad (4)$$

Beide Varianten führen erfindungsgemäß nun dazu, dass der Einfluss des Jochs aus den Messungen eliminierbar ist. Sohin ist es auch in weiterer Folge möglich, eine Differenz der beiden erfassten Messdaten zu bilden und dies als Maß in die Gehaltsbestimmung für den magnetisierbaren und/oder nicht-magnetisierbaren Gehaltsanteil der Probe eingehen zu lassen.

Durch Messung des magnetischen Flusses der Referenzprobe $\Phi_{\text{ref}}$ und der Probe $\Phi_{\text{p}}$, kann nämlich der magnetisierbare Gehaltsanteil der Probe - bei bekanntem magnetisierbarem Gehaltsanteil der Referenzprobe - aus dem Verhältnis der magnetischen Widerstände $R_{\text{ref}}$ und $R_{\text{p}}$ bestimmt werden (durch Subtraktion und Umformung der Gleichungen (2)-(1) bzw. (4)-(3)). Damit ist ein einfaches Auswerteverfahren zum Vergleich der Messdaten von Probe und Referenzprobe geschaffen, welches unter anderem durch seine Einfachheit in der Berechnung eine zuverlässigere und zugleich schnellere Bestimmung des magnetisierbaren bzw. nicht-magnetisierbaren Gehaltsanteils einer Probe ermöglichen kann.

Werden die magnetischen Wechselfelder (B) über eine induktiv über das Joch mit der Erregerspule gekoppelten Messeinrichtung gemessen, so kann eine direkte Bestimmung der magnetischen Flussdichte im Joch ermöglicht werden. Insbesondere bevorzugt ist die Messeinrichtung hierbei als Messspule über dem Joch ausgeführt. Dabei wird die in der Messspule induzierte Spannung V(t) durch einen Integrator aufintegriert, um die Magnetfeldstärke (B) zu bestimmen. Ein einfaches und zugleich zuverlässiges Verfahren kann somit geschaffen werden.

Werden bei der Gehaltsbestimmung des magnetisierbaren und/oder nicht-magnetisierbaren Gehaltsanteils in der Probe die relative Permeabilität der Probe und der Referenzprobe bestimmt, so ist ein physikalisch aufschlussreicher Parameter, welcher den magnetisierbaren Gehalt der Probe widerspiegelt, bestimmbar. Ein zuverlässiges Verfahren kann somit geschaffen werden.

Um besonders einfach aus den Differenzdaten auf den Eisengehalt rückschließen zu können, kann vorteilhaft sein, wenn die relative Permeabilität der Probe als Summe der relativen Permeabilitäten von reinem Eisen und von Luft modelliert wird. In anderen Worten, der magnetische Widerstand der Probe als auch der Referenzprobe kann als eine Serienschaltung einer Schicht mit 100% Eisengehalt und einer Schicht Luft (mit 0% Eisengehalt) modelliert werden. Dadurch kann sich ein einfacher Zusammenhang zwischen Messdaten/Differenzdaten und Eisengehalt ergeben, was nicht nur ein schnelles, sondern auch ein zuverlässiges Verfahren ermöglichen kann. Im Allgemeinen wird erwähnt, dass sich als vorteilhaft erweisen kann, wenn der magnetisierbare Anteil der Referenzprobe ähnlich hoch ist wie der magnetisierbare Anteil der zu vermessenden Probe, um damit die Empfindlichkeit/Messgenauigkeit der Vorrichtung zu erhöhen. Vorzugsweise ist der magnetisierbare Anteil der Referenzprobe der Mittelwert aus den zu erwarten den magnetisierbaren Anteilen der zu bestimmenden Proben.

Verfahrenstechnisch einfach lässt sich das Verfahren realisieren, wenn die gleiche magnetische Wechselfeldstärke durch Regelung des Spulenstroms i(t) der Erregerspule in Probe und Referenzprobe eingeprägt wird. So kann etwa ein in Frequenz und Amplitude gleicher Strom i(t) durch die Erregerspule laufen und in dieser eine definierte magnetische Wechselfeldstärke induzieren. Zu diesem Zweck kann beispielsweise eine Stromregeleinrichtung in dem Verfahren angeordnet sein, um der Spule einen definierten Strom i(t) einzuprägen.

Alternativ kann sich ein zuverlässiges Verfahren ergeben, wenn das gleiche magnetische Wechselfeld durch dessen Regelung in Probe und Referenzprobe eingeprägt wird. Dies kann vorzugsweise durch Messung des magnetischen Wechselfelds in einer Messspule erfolgen, wobei die induzierte Spannung in der Messspule einem Integrator zugeführt wird, welcher wiederum mit einem Regler verbunden ist, um so das magnetische Wechselfeld im Joch zu regeln.

Liegt zudem der Arbeitspunkt der Wechselfeldstärke bei der Messdatenerfassung im Bereich des flachen Kurvenverlaufs der magnetischen Permeabilität des Jochs, so kann ein besonders zuverlässiges Verfahren geschaffen werden. Insbesondere kann dabei der Näherungsfehler bei Annahme einer konstanten Permeabilität des Jochs weiter reduziert werden.

Die Erfindung hat sich zudem die Aufgabe gestellt, eine Vorrichtung zur schnellen und zuverlässigen Durchführung des erfindungsgemäßen Verfahrens zu schaffen. Zudem soll die Vorrichtung den magnetisierbaren und/oder nicht-magnetisierbaren Gehaltsanteil der Probe besonders exakt bestimmen können.

Die Erfindung löst die gestellte Aufgabe durch eine Vorrichtung nach Anspruch 8.

Indem die Vorrichtung eine mit dem Joch induktiv gekoppelte erste Messspule aufweist, von der die Messeinrichtung Messdaten erfasst, und indem die Vorrichtung mit der Erregerspule zusammenwirkende Regeleinrichtung zur Einprägung der gleichen magnetischen Wechselfeldstärke oder des gleichen magnetischen Wechselfelds im ersten Luftspalt für die Referenzprobe oder die Probe aufweist, und indem die Vorrichtung eine Differenzschaltung aufweist, die zur Erzeugung von Differenzdaten aus den Messdaten von Referenzprobe und Probe ausgebildet ist, und in dem die Vorrichtung eine mit einer mit der Differenzschaltung verbundenen Auswerteeinrichtung aufweist, die zur Gehaltsbestimmung für den magnetisierbaren und/oder nicht-magnetisierbaren Gehaltsanteil in der Probe in Abhängigkeit der Differenzdaten ausgebildet ist, kann auf konstruktive Weise sichergestellt werden, dass die von Probe und Referenzprobe erfassten Messdaten vergleichbar sind - und damit der magnetisierbare und/oder nicht-magnetisierbare Gehaltsanteil der Probe exakt bestimmt werden kann.

Die Genauigkeit der Vorrichtung kann weiter erhöht werden, wenn der Arbeitspunkt der Wechselfeldstärke der Erregerspule bei der Messdatenerfassung im Bereich des flachen Kurvenverlaufs der magnetischen Permeabilität des Jochs liegt.

Kurze Beschreibung der Zeichnungen

In den Figuren ist beispielsweise der Erfindungsgegenstand anhand einer Ausführungsvariante näher dargestellt. Es zeigen

Fig. 1 eine Vorrichtung zur Durchführung des erfindungsgemäßen Verfahrens,
Fig. 2 eine grafische Darstellung der Magnetisierungskurven im Messverfahren,
Fig. 3 eine weitere nicht erfindungsgemäße Vorrichtung und
Fig. 4 eine dritte nicht erfindungsgemäße Vorrichtung.

Wege zur Ausführung der Erfindung

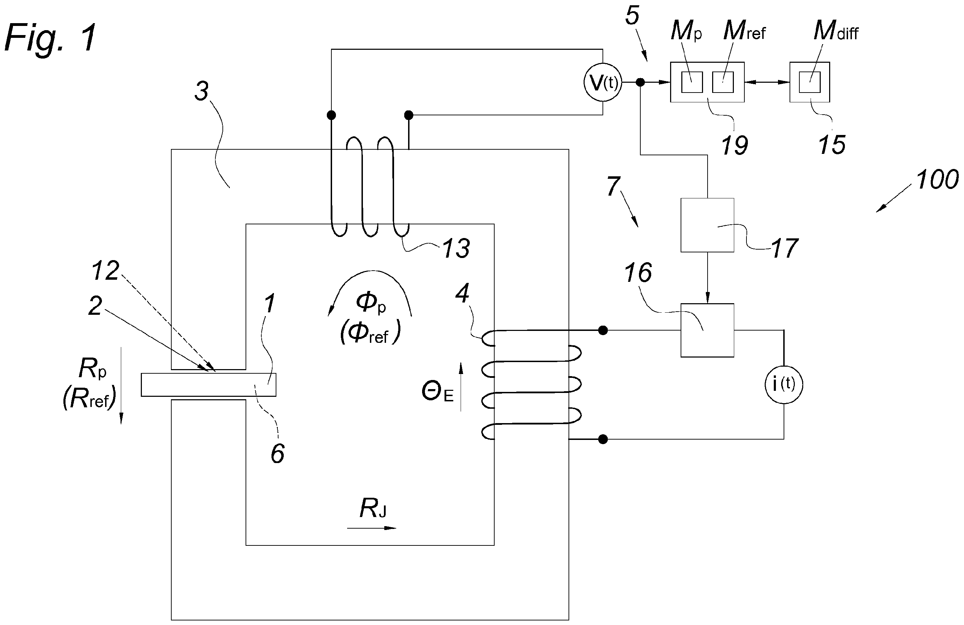

In Fig. 1 ist eine Vorrichtung 100 zur Durchführung des erfindungsgemäßen Verfahrens zur zerstörungsfreien Gehaltsbestimmung des magnetisierbaren bzw. nicht-magnetisierbaren Anteils einer Probe 1 dargestellt.

Die Probe 1 wird dabei in einen Luftspalt 2 eines magnetisch leitenden Jochs 3 eingebracht. Über die Erregerspule 4 wird das Joch 3 mit einer magnetischen Feldstärke H beaufschlagt, welches eine magnetische Durchflutung $\Theta_E$ in der Spule induziert und im Joch 3 - und damit auch in der Probe 1 - ein magnetisches Wechselfeld B, bzw. ein magnetischer Fluss $\Phi_{ref}$ bzw. $\Phi_p$ erzeugt.

Eine Messeinrichtung 5 wiederum ist mit dem Joch 3 induktiv gekoppelt und ist somit in der Lage, Messdaten $M_p$ der Probe 1 zu erfassen. Derart erfasste erste Messdaten $M_p$ der Probe 1 werden danach mit zweiten Messdaten $M_{ref}$ von einer Referenzprobe 6 verglichen, die mit derselben Vorrichtung 1 gemessen werden. Zudem ist von der Referenzprobe 6 der magnetisierbare bzw. nicht-magnetisierbare Gehaltsanteil bekannt.

Um nun vergleichbare Messdaten $M_p$, $M_{ref}$ zwischen Referenzprobe 6 und Probe 1 zu schaffen, wird erfindungsgemäß vorgeschlagen, stets die gleiche magnetische Wechselfeldstärke H in Probe 1 und Referenzprobe 6 einzuprägen. Hierzu ist ein Regelkreis 7 vorgesehen, der einen Stromregler 16 aufweist und damit einen Wechselstrom i(t) derart einprägt, dass Probe 1 und Referenzprobe 6 mit der gleiche magnetischen Wechselfeldstärke H belastet werden.

Alternativ kann mit Hilfe des Regelkreises 7 auch das gleiche magnetische Wechselfeld B in Probe 1 und Referenzprobe 6 eingeprägt werden, was in Fig. 1 strichliert eingezeichnet ist. Um dies zu erreichen, wird die induzierte Spannung V(t) in einer Messspule 13 gemessen und einem Integrator 17 zugeführt, welcher das Wechselfeld B errechnet. Das Ergebnis des Integrators 17 wird nun wieder dem Stromregler 16 zugeführt, welcher dafür sorgt, dass das gewünschte magnetische Wechselfeld im Joch 3 herrscht.

Erfindungsgemäß wird somit die gleiche magnetische Wechselfeldstärke H jeweils auf Probe 1 und Referenzprobe 6 eingeprägt, wobei über die Messeinrichtung 5 die magnetischen Wechselfelder B gemessen werden. Hierzu wird der jeweils komplementäre Wert (B bzw. H) von der Messeinrichtung 5 erfasst und die erfassten Messdaten $M_p$, $M_{ref}$ einer Differenzschaltung 19 zugeführt - und dort zur Differenzberechnung gespeichert. Zur Bestimmung des magnetisierbaren bzw. nicht-magnetisierbaren Gehaltsanteils in der Probe 1 wird schließlich von der Differenzschaltung 19 die Differenz dieser hintereinander gemessenen Messdaten $M_p$, $M_{ref}$ gebildet bzw. werden Differenzdaten $M_{diff}$ gebildet - und der Auswerteeinrichtung 15 zugeführt, welche diese Differenzdaten $M_{diff}$ als Maß bei der Gehaltsbestimmung für den magnetisierbaren und/oder nicht-magnetisierbaren Gehaltsanteil der Probe 1 verwendet. In anderen Worten kann aus der Differenz der magnetischen Wechselfelder $B_{ref}$ und $B_p$ auf den Gehaltsanteil an magnetisierbarem bzw. nicht-magnetisierbarem Material in der Probe rückgeschlossen werden.

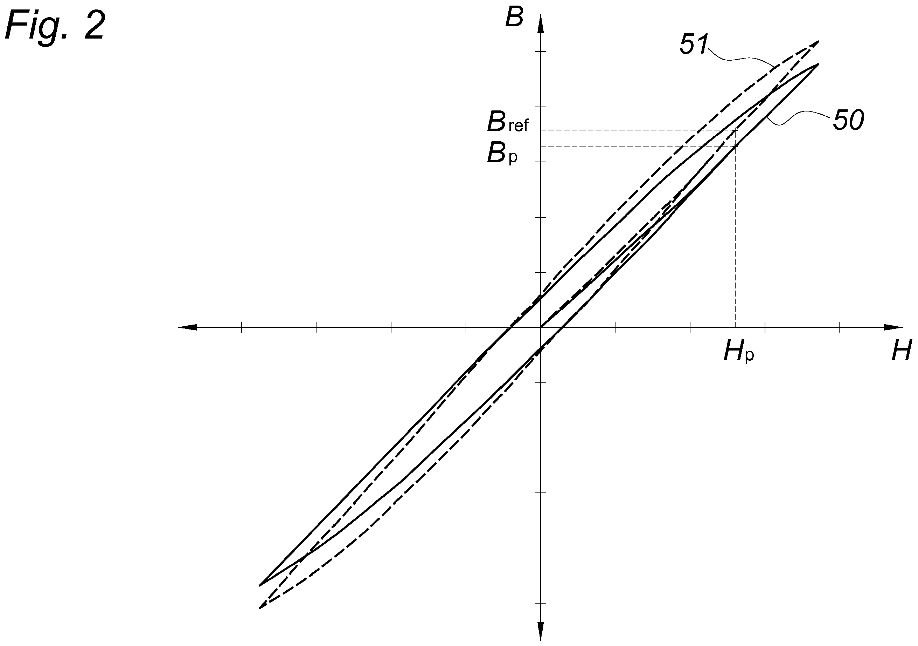

Das Ergebnis einer solchen Messung ist in Fig. 2 dargestellt. Hierbei wurden jeweils in Probe 1 und Referenzprobe 6 identische Wechselfeldstärken H eingeprägt und eine Hystereseschleife 50 der Probe als auch eine Hystereseschleife 51 der Referenzprobe über die Messeinrichtung 5 aufgezeichnet. Beide Hystereseschleifen 50, 51 können nun zu einem Punkt $H_p$ identischer Feldstärken unterschiedliche Magnetfelder $B_p$ und $B_{ref}$ aufweisen. Aus der Differenz der Magnetfeldstärken kann nun beispielsweise auf den Gehaltsanteil an magnetisierbarem Material in der Probe 1 rückgeschlossen werden - da der Gehaltsanteil an magnetisierbarem Material in der Referenzprobe 6 bekannt ist. Die äquivalente Überlegung kann für den nicht-magnetisierbaren Gehaltsanteil durchgeführt werden. Als besonders vorteilhaft kann sich dabei herausstellen, wenn die Messdaten $M_{ref}$, $M_p$ im flachen Bereich bzw. Kurvenverlauf der magnetischen Permeabilität $\mu_J$ des Jochs aufgezeichnet und zur Auswertung herangezogen werden, da diese dann als nahezu konstant angenommen werden kann und somit aus der Differenzberechnung der Magnetfelder herausfällt. Hierzu liegt der Arbeitspunkt der Wechselfeldstärke H der Erregerspule 4 bei der Messdatenerfassung im Bereich des flachen Kurvenverlaufs der magnetischen Permeabilität des Jochs 3. Aus der Differenz der Magnetfeldstärken ist somit auf die Änderung der relativen Permeabilität $\mu_r$ zwischen Probe und Referenzprobe schließbar.

Alternativ ist es jedoch ebenso möglich, bei der Messdatenerfassung identische magnetische Wechselfelder B in die Probe 1 bzw. Referenzprobe 6 einzuprägen. Die Messeinrichtung 5 erfasst demgemäß die Feldstärken H bei jeweils gleichem Magnetfeld B in Probe 1 und Referenzprobe 6. Exemplarische Messdaten $M_{ref}$, $M_p$ zu diesem Verfahrensschritt wurden in den Figuren jedoch nicht dargestellt.

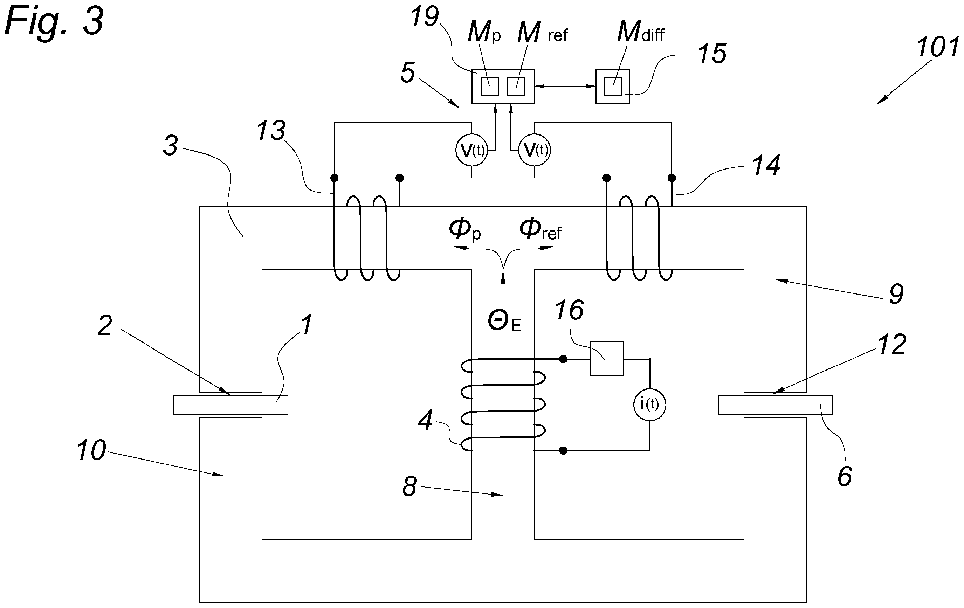

Fig. 3 zeigt eine nicht erfindungsgemäße Vorrichtung 101 mit einem magnetisch leitenden Joch 3, welches einen Mittelsteg 8 und zwei daran anschließende seitliche Schenkel 9, 10 aufweist. Beide Schenkel 9, 10 zeigen jeweils einen Luftspalt 2, 12 - wobei der erste Luftspalt 2 zum Einsetzen der Probe 1 und der zweite Luftspalt 12 zum Einsetzen einer Referenzprobe 6 ausgebildet ist. Der magnetisierbare Gehaltanteil der Referenzprobe 6 ist dabei bekannt. Am Mittelsteg 8 des Jochs 3 ist eine Erregerspule 4 vorgesehen, während an beiden Schenkeln 9, 10 eine erste und zweite Messspule 13, 14 vorgesehen sind, welche mit dem Joch 3 induktiv gekoppelt sind. Eine Messeinrichtung 5 erfasst dabei erste Messdaten von der ersten Messspule 13 - also von der Probe 1 - und zweite Messdaten von der zweiten Messspule 14 - also von der Referenzprobe 6.

Die Messeinrichtung 5 erzeugt Differenzdaten $M_{diff}$ aus den ersten und zweiten Messdaten und ist wiederum mit einer Auswerteeinrichtung 15 verbunden, welche die Differenzdaten $M_{diff}$ zu Bestimmung des magnetisierbaren bzw. nicht-magnetisierbaren Gehaltsanteils heranzieht.

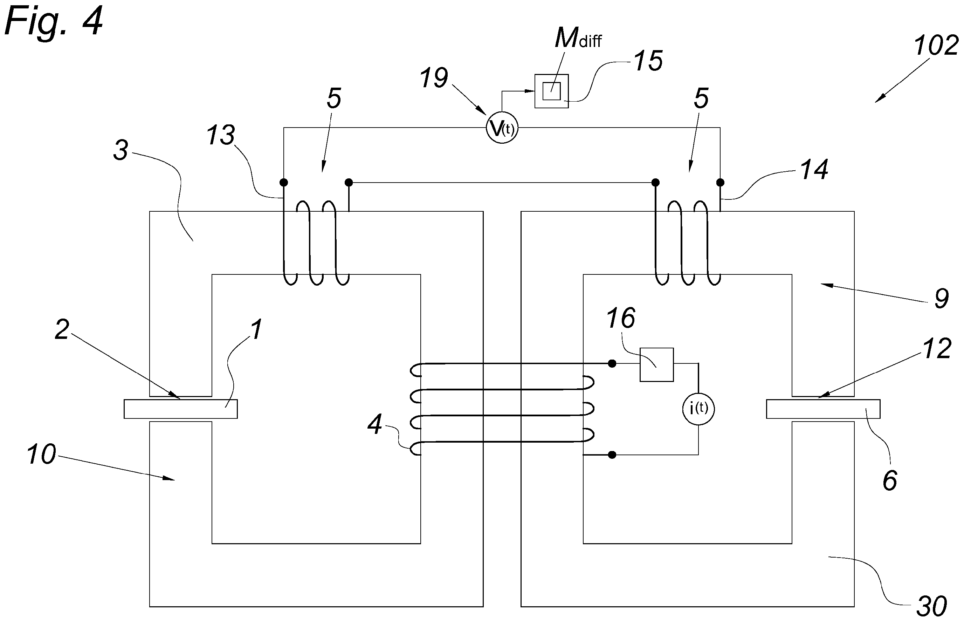

Die Messspulen 13, 14 der Messeinrichtung 5 können in einer anderen Ausführungsform aber auch in Serie geschaltet werden, wie dies beispielsweise zur nicht erfindungsgemäßen Vorrichtung 102 nach Fig. 4 dargestellt ist. Aufgrund dieser Verschaltung kann durch Subtraktion der Induktionsspannungen V(t) in den Messspulen 13, 14 gleichzeitig auch eine konstruktiv einfache Differenzschaltung 19 ausgebildet werden. Zudem unterscheidet sich die nach Fig. 4 dargestellte Vorrichtung 102 von jener nach Fig. 3 dargestellten dadurch, dass in Fig. 3 nicht ein einzelnes Joch 3, sondern zwei Joche 3, 30 vorgesehen sind. Diese Joche 3, 30 weisen je eine Messspule 13, 14 und je einen Luftspalt 2, 12 auf. Diese Bauform der Vorrichtung 102 eröffnet die Option, ein Joch 3, 30 zu wechseln, was die Vorrichtung 102 wartungsfreundlicher macht.


**Patentansprüche**

1. Verfahren zur zerstörungsfreien Gehaltsbestimmung des magnetisierbaren und/oder nicht-magnetisierbaren Anteils einer Probe (1), bei dem in einem Luftspalt (2) eines magnetisch leitenden Jochs (3) die Probe (1) vorgesehen wird, durch eine magnetische Wechselfeldstärke (H) einer Erregerspule (4) im Joch (3) ein magnetisches Wechselfeld (B) erzeugt und mit mindestens einer induktiv mit dem Joch (3) gekoppelten Messeinrichtung (5) erste Messdaten ($M_p$) der Probe (1) erfasst werden, und mit Hilfe eines Vergleichs der ersten Messdaten ($M_p$) mit zweiten Messdaten ($M_{ref}$) von einer Referenzprobe (6), mit bekanntem magnetisierbarem und/oder nicht-magnetisierbarem Gehaltsanteil, der magnetisierbare und/oder nicht-magnetisierbare Gehaltsanteil in der Probe (1) bestimmt wird, **dadurch gekennzeichnet, dass** bei der Erfassung der ersten und zweiten Messdaten ($M_p$, $M_{ref}$) der Probe (1) und Referenzprobe (6) mit Hilfe der Erregerspule (4) die gleiche magnetische Wechselfeldstärke (H) oder das gleiche magnetische Wechselfeld (B) sowohl in die Referenzprobe (6) als auch in die Probe (1) eingeprägt wird, und die Differenz der beiden erfassten Messdaten ($M_p$, $M_{ref}$) als Maß in die Gehaltsbestimmung für den magnetisierbaren und/oder nicht-magnetisierbaren Gehaltsanteil der Probe (1) eingeht.

2. Verfahren nach Anspruch 1, **dadurch gekennzeichnet, dass** die magnetischen Wechselfelder (B) über eine induktiv über das Joch (3) mit der Erregerspule gekoppelte Messeinrichtung (5), insbesondere mit einer Messspule (13), gemessen werden.

3. Verfahren nach Anspruch 1 oder 2, **dadurch gekennzeichnet, dass** bei der Gehaltsbestimmung des magnetisierbaren und/oder nicht-magnetisierbaren Gehaltsanteils in der Probe (1) die relative Permeabilität der Probe (1) und der Referenzprobe (6) bestimmt werden.

4. Verfahren nach einem der Ansprüche 1 bis 3, **dadurch gekennzeichnet, dass** die relative Permeabilität der Probe (1) als Summe der relativen Permeabilitäten von reinem Eisen und von Luft modelliert wird.

5. Verfahren nach einem der Ansprüche 1 bis 4, **dadurch gekennzeichnet, dass** die gleiche magnetische Wechselfeldstärke (H) durch Regelung des Spulenstroms i(t) der Erregerspule in Probe und Referenzprobe eingeprägt wird.

6. Verfahren nach einem der Ansprüche 1 bis 5, **dadurch gekennzeichnet, dass** das gleiche magnetische Wechselfeld (B) durch Regelung desselben in Probe (1) und Referenzprobe (6) eingeprägt wird.

7. Verfahren nach einem der Ansprüche 1 bis 6, **dadurch gekennzeichnet, dass** der Arbeitspunkt der Wechselfeldstärke (H) bei der Messdatenerfassung im Bereich des flachen Kurvenverlaufs der magnetischen Permeabilität des Jochs (3) liegt.

8. Vorrichtung zur zerstörungsfreien Gehaltsbestimmung des magnetisierbaren und/oder nicht-magnetisierbaren Anteils einer Probe (1) mit einem ersten magnetisch leitenden Joch (3), das einen ersten Luftspalt (2) zur wahlweisen Aufnahme der Probe (1) oder einer Referenzprobe (6) aufweist, mit einer am Joch (3) vorgesehenen Erregerspule (4), mit einer mit dem ersten Joch (3) induktiv gekoppelten Messeinrichtung (5) und mit einer mit der Messeinrichtung (5) verbundenen Auswerteeinrichtung (15), die zur Gehaltsbestimmung für den magnetisierbaren und/oder nicht-magnetisierbaren Gehaltsanteil der Probe (1) ausgebildet ist, **dadurch gekennzeichnet, dass** die Vorrichtung (100) eine mit dem Joch (3) induktiv gekoppelte erste Messspule (13) aufweist, von der die Messeinrichtung (5) Messdaten ($M_{ref}$, $M_p$) erfasst, und dass die Vorrichtung (100) eine, mit der Erregerspule (4) zusammenwirkende Regeleinrichtung (7) zur Einprägung der gleichen magnetischen Wechselfeldstärke (H) oder des gleichen magnetischen Wechselfelds (B) im ersten Luftspalt (2) für die Referenzprobe (6) oder die Probe (1) aufweist, dass die Vorrichtung (100) eine Differenzschaltung (19) aufweist, die zur Erzeugung von Differenzdaten ($M_{diff}$) aus den Messdaten ($M_{ref}$, $M_p$) von Referenzprobe (6) und Probe (1) ausgebildet ist, und dass die Vorrichtung (100) eine mit einer mit der Differenzschaltung (19) verbundenen Auswerteeinrichtung (15) aufweist, die zur Gehaltsbestimmung für den magnetisierbaren und/oder nicht-magnetisierbaren Gehaltsanteil in der Probe (1) in Abhängigkeit der Differenzdaten ($M_{diff}$) ausgebildet ist.

9. Vorrichtung nach Anspruch 8, **dadurch gekennzeichnet**, der Arbeitspunkt der Wechselfeldstärke (H) der Erregerspule (4) bei der Messdatenerfassung im Bereich des flachen Kurvenverlaufs der magnetischen Permeabilität des Jochs (3) liegt.

## Claims

1. A method for the non-destructive determination of the content of the magnetizable and/or non-magnetizable portion of a sample (1), in which the sample (1) is provided in an air gap (2) of a magnetically conductive yoke (3), an alternating magnetic field (B) is generated by means of an alternating magnetic field strength (H) of an excitation coil (4) in the yoke (3), and first measurement data ($M_p$) relating to the sample (1) are collected using at least one measuring device (5) which is inductively coupled to the yoke (3), and the magnetizable and/or non-magnetizable content portion in the sample (1) is determined by comparing the first measurement data ($M_p$) to second measurement data ($M_{ref}$) relating to a reference sample (6) that has a known magnetizable and/or non-magnetizable content portion, **characterized in that** during the collection of the first and second measurement data ($M_p$, $M_{ref}$) relating to the sample (1) and the reference sample (6) with the aid of the excitation coil (4), the same alternating magnetic field strength (H) or the same alternating magnetic field (B) is applied to both the reference sample (6) and the sample (1) and the difference between the two collected sets of measurement data ($M_{ref}$, $M_p$) is included as a measure in the determination of the content for the magnetizable and/or non-magnetizable content portion of the sample (1).

2. The method according to claim 1, **characterized in that** the alternating magnetic fields (B) are measured using a measuring device (5), more particularly with a measuring coil (13), that is inductively coupled to the excitation coil via the yoke (3).

3. The method according to claim 1 or 2, **characterized in that** when determining the content portion of the magnetizable and/or non-magnetizable portion in the sample (1), the relative permeability of the sample (1) and the reference sample (6) are determined.

**4.** The method according to one of claims 1 through 3, **characterized in that** the relative permeability of the sample (1) is modeled as the sum of the relative permeabilities of pure iron and air.

**5.** The method according to one of claims 1 through 4, **characterized in that** the same alternating magnetic field strength (H) is applied to the sample and the reference sample by regulating the coil current i(t) of the excitation coil.

**6.** The method according to one of claims 1 through 5, **characterized in that** the same alternating magnetic field (B) is applied to the sample (1) and the reference sample (6) by regulating said field.

**7.** The method according to one of claims 1 through 6, **characterized in that** during the measurement data collection, the operating point of the alternating field strength (H) lies in the region of the flat curvature of the magnetic permeability of the yoke (3).

**8.** An apparatus for the non-destructive determination of the content of the magnetizable and/or non-magnetizable portion of a sample (1) having a first magnetically conductive yoke (3) that has a first air gap (2) for selectively receiving the sample (1) or a reference sample (6), having an excitation coil (4) provided on the yoke (3), having a measuring device (5) inductively coupled to the yoke (3), and having an evaluation device (15) connected to the measuring device (5), which is embodied for determining the content of the magnetizable and/or non-magnetizable content portion of a sample (1), **characterized in that** the apparatus (100) has a first measuring coil (13), which is inductively coupled to the yoke (3), from which the measuring device (5) collects measurement data ($M_{ref}$, $M_p$); the apparatus (100) has a regulating device (7) that cooperates with the excitation coil (4) in order to apply the same alternating magnetic field strength (H) or the same alternating magnetic field (B) in the first air gap (2) for the reference sample (6) or the sample (1); the apparatus (100) has a differential circuit (19) that is embodied for generating difference data ($M_{diff}$) from the measurement data ($M_{ref}$, $M_p$) relating to the reference sample (6) and the sample (1); and the apparatus (100) has an evaluation device (15) that is connected to the differential circuit (19) and is embodied for determining the content of the magnetizable and/or non-magnetizable content portion in the sample (1) as a function of the difference data ($M_{diff}$).

**9.** The apparatus according to claim 8, **characterized in**, during the measurement data collection, the operating point of the alternating field strength (H) of the excitation coil (4) lies in the region of the flat curvature of the magnetic permeability of the yoke (3).

**Revendications**

**1.** Procédé pour la détermination non destructive de la part magnétisable et/ou non magnétisable d'un échantillon (1), dans lequel l'échantillon (1) est placé dans un entrefer (2) d'une culasse magnétiquement conductrice (3), un champ magnétique (B) est généré par une intensité de champ magnétique alternatif (H) d'une bobine excitatrice (4) de la culasse (3) et des premières données de mesure ($M_p$) de l'échantillon (1) sont acquises avec au moins un dispositif de mesure (5) couplé par induction avec la culasse (3) et la part magnétisable et/ou non magnétisable dans l'échantillon (1) est déterminée à l'aide d'une comparaison des premières données de mesure ($M_p$) avec des deuxièmes données de mesure ($M_{ref}$) d'un échantillon de référence (6) contenant une part magnétisable et/ou non magnétisable connue, **caractérisé en ce que**, lors de l'acquisition des premières et deuxièmes données de mesure ($M_p$, $M_{ref}$) de l'échantillon (1) et de l'échantillon de référence (6), la même intensité de champ magnétique alternatif (H) ou le même champ magnétique alternatif (B) sont appliqués à l'aide de la bobine excitatrice (4) dans l'échantillon de référence (6) et dans l'échantillon (1) et la différence entre les deux données de mesure acquises ($M_p$, $M_{ref}$) est utilisée comme valeur de mesure dans la détermination de la part magnétisable et/ou non magnétisable de l'échantillon (1).

**2.** Procédé selon la revendication 1, **caractérisé en ce que** les champs magnétiques alternatifs (B) sont mesurés à l'aide d'un dispositif de mesure (5) couplé par induction avec la bobine excitatrice par l'intermédiaire de la culasse (3), en particulier avec une bobine de mesure (13).

**3.** Procédé selon la revendication 1 ou 2, **caractérisé en ce que**, lors de la détermination de la part magnétisable et/ou non magnétisable de l'échantillon (1), la perméabilité relative de l'échantillon (1) et de l'échantillon de référence (6) est déterminée.

**4.** Procédé selon l'une des revendications 1 à 3, **caractérisé en ce que** la perméabilité relative de l'échantillon (1) est modélisée comme la somme des perméabilités relatives du fer pur et de l'air.

5. Procédé selon l'une des revendications 1 à 4, **caractérisé en ce que** la même intensité de champ magnétique alternatif (H) est appliquée dans l'échantillon et l'échantillon de référence grâce à la régulation du courant de bobine i(t) de la bobine excitatrice.

6. Procédé selon l'une des revendications 1 à 5, **caractérisé en ce que** le même champ magnétique alternatif (B) est appliqué dans l'échantillon (1) et l'échantillon de référence (6) grâce à la régulation de ce champ.

7. Procédé selon l'une des revendications 1 à 6, **caractérisé en ce que** le point de fonctionnement de l'intensité de champ alternatif (H) lors de l'acquisition des données de mesure se situe dans la plage où la courbe de perméabilité magnétique de la culasse (3) est plate.

8. Dispositif pour la détermination non destructive de la part magnétisable et/ou non magnétisable d'un échantillon (1) avec une première culasse magnétiquement conductrice (3) qui présente un premier entrefer (2) pour recevoir soit l'échantillon (1), soit un échantillon de référence (6), avec une bobine excitatrice (4) prévue sur la culasse (3), avec un dispositif de mesure (5) couplé par induction avec la première culasse (3) et avec un dispositif d'analyse (15) communiquant avec le dispositif de mesure (5), qui est conçu pour déterminer la part magnétisable et/ou non magnétisable de l'échantillon (1), **caractérisé en ce que** le dispositif (100) comprend une première bobine de mesure (13) couplée par induction avec la culasse (3), par laquelle le dispositif de mesure (5) acquiert des données de mesure ($M_{ref}$, $M_p$), et **en ce que** le dispositif (100) comporte un dispositif de régulation (7) coopérant avec la bobine excitatrice (4) pour appliquer la même intensité de champ magnétique alternatif (H) ou le même champ magnétique alternatif (B) pour l'échantillon de référence (6) ou l'échantillon (1) dans le premier entrefer (2), **en ce que** le dispositif (100) présente un circuit de calcul de différence (19) conçu pour produire des données de différence ($M_{diff}$) à partir des données de mesure ($M_{ref}$, $M_p$) de l'échantillon de référence (6) et de l'échantillon (1) et **en ce que** le dispositif (100) comporte un dispositif d'analyse (15) communiquant avec le circuit de calcul de différence (19), qui est conçu pour déterminer la part magnétisable et/ou non magnétisable de l'échantillon (1) en fonction des données de différence ($M_{diff}$).

9. Dispositif selon la revendication 8, **caractérisé en ce que** le point de fonctionnement de l'intensité de champ alternatif (H) de la bobine excitatrice (4) lors de l'acquisition des données de mesure se situe dans la plage où la courbe de perméabilité magnétique de la culasse (3) est plate.

*Fig. 1*

$M_p$  $M_{ref}$  $M_{diff}$

5

19  15

100

7

17

16

3

13

$\Phi_p$
$(\Phi_{ref})$

12

2

1

4

$R_p$
$(R_{ref})$

$\Theta_E$

6

$R_J$

V(t)

i(t)

EP 3 494 394 B1

*Fig. 2*

Fig. 3

Fig. 4

EP 3 494 394 B1

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- EP 0267896 A2
- US 3337795 A
- US 2755433 A